# EUROPEAN PATENT APPLICATION

(11) **EP 3 584 837 A1**
(43) Date of publication of application: **25.12.2019**
(21) Application number: 19173106.6
(22) Date of filing: 07.05.2019
(51) Int. Cl.: H01L 27/11548, H01L 27/11595, H01L 27/11556, H01L 21/20, H01L 27/11526, H01L 21/18

(54) **THREE-DIMENSIONAL (3D) MEMORY WITH CONTROL CIRCUITRY AND ARRAY IN SEPARATELY PROCESSED AND BONDED WAFERS**

(30) Priority: 18.06.2018 US 201816011129
(71) Applicant: INTEL Corporation, Santa Clara, CA 95054 (US)
(72) Inventor: HASNAT, Khaled, San Jose, CA California 95135 (US); MAJHI, Prashant, San Jose, CA California 95121 (US)
(74) Representative: Rummler, Felix

(57) **Abstract**

Three-dimensional (3D) memory with control the array and control circuitry in separately processed and bonded wafers is described. In one example, a non-volatile storage component includes a first die including a three-dimensional (3D) array of non-volatile storage cells and a second die bonded with the first die. The second die includes CMOS (complementary metal oxide semiconductor) circuitry to access the 3D array of non-volatile storage cells. By processing the CMOS circuitry and array on separate wafers, the periphery CMOS and interconnects do not have to withstand the thermal cycles involved in processing the memory array, which enables optimizations for the CMOS transistors and the use low resistive material for interconnects.

## Description

### FIELD

The descriptions are generally related to memory and storage devices, and more particular descriptions are related to a method of making a 3D NAND flash memory by processing periphery CMOS circuitry and array devices in separate wafers and subsequently bonding them.

### BACKGROUND

Flash storage, such as NAND flash memory, is a nonvolatile storage medium. Nonvolatile storage refers to a storage having a state that is determinate even if power is interrupted to the device. Flash memory can be used as memory (e.g., system memory) or as a storage device. There is a trend for systems across the mobile, client, and enterprise segments to use flash memory for storage (e.g., such as solid state drives (SSDs)). One type of NAND flash memory is three dimensional (3D) NAND flash memory, in which vertical NAND strings make up the storage array. Although the 3D NAND flash arrays can store more bits in a given area than two dimensional (2D) NAND, there is continued interest in denser, faster, and more power efficient data storage.

### BRIEF DESCRIPTION OF THE DRAWINGS

The following description includes discussion of figures having illustrations given by way of example of implementations of embodiments of the invention. The drawings should be understood by way of example, and not by way of limitation. As used herein, references to one or more "embodiments" or "examples" are to be understood as describing a particular feature, structure, and/or characteristic included in at least one implementation of the invention. Thus, phrases such as "in one embodiment" or "in one example" appearing herein describe various embodiments and implementations of the invention, and do not necessarily all refer to the same embodiment. However, they are also not necessarily mutually exclusive.
**Figures 1A-1C** illustrate an example of a cross-section of a 3D flash memory component with the CMOS periphery and the memory array on the same wafer at various stages of processing.
**Figures 2A-2D** illustrate an example of a cross-section of a 3D flash memory component with the CMOS periphery and the memory array on the same wafer at various stages of processing.
**Figure 3** illustrates a cross-section of a 3D storage component in which the CMOS circuitry and some of the interconnects are processed on a different wafer than the array.
**Figures 4A-4E** illustrate an example of a 3D flash component with the CMOS circuitry and array on separate bonded dies in various stages of processing.
**Figure 5** is a flow diagram of an example of a method of forming a 3D flash storage device with the array and CMOS on separately processed and bonded wafers.
**Figure 6** illustrates a block diagram of a flash storage device 602 in which a 3D storage component with the array and CMOS circuitry on separately processed and bonded wafers can be included, in accordance with one example.
**Figure 7** provides an exemplary depiction of a computing system 700 that can include a 3D storage device in which the array and CMOS circuitry are formed on separately processed and bonded wafers.

Descriptions of certain details and implementations follow, including a description of the figures, which may depict some or all of the embodiments described below, as well as discussing other potential embodiments or implementations of the inventive concepts presented herein.

### DETAILED DESCRIPTION

Three-dimensional (3D) memory with control circuitry and an array in separately processed and bonded wafers is described herein.

One type of 3D memory is 3D flash memory, which can also be referred to as 3D flash storage. One example of 3D flash memory is 3D NAND (not AND) flash memory. 3D memory includes one or more arrays of storage cells and control circuitry to access the storage cells. Typically, control circuitry for accessing 3D flash storage arrays includes CMOS

(complementary metal oxide semiconductor) circuitry. The control or CMOS circuitry can also be referred to as the "periphery."

For conventional 3D NAND Flash memory, the periphery CMOS circuitry and the NAND memory array are built on a single wafer. As a result, the CMOS periphery is either built next to the NAND array or underneath the array. In the case where the CMOS periphery is built next to the NAND array, the CMOS periphery occupies a large portion of the die, increasing the overall die size. For both the cases, the performance of the CMOS and choice of material for interconnects are limited due to thermal processing involved in building the memory array.

In contrast to conventional 3D memories, a 3D memory component is formed by processing the CMOS periphery and the memory array on separate wafers. The two wafers are then bonded with a high alignment accuracy (e.g., an alignment accuracy of 100nm or less) to complete the memory component. By processing the CMOS periphery and the memory array on separate wafers, the periphery CMOS and interconnects do not have to withstand the thermal cycles involved in processing the memory array. Therefore, processing the periphery CMOS on a wafer separate from the array enables better optimization of the CMOS transistors and enables the use low resistive material for the interconnects.

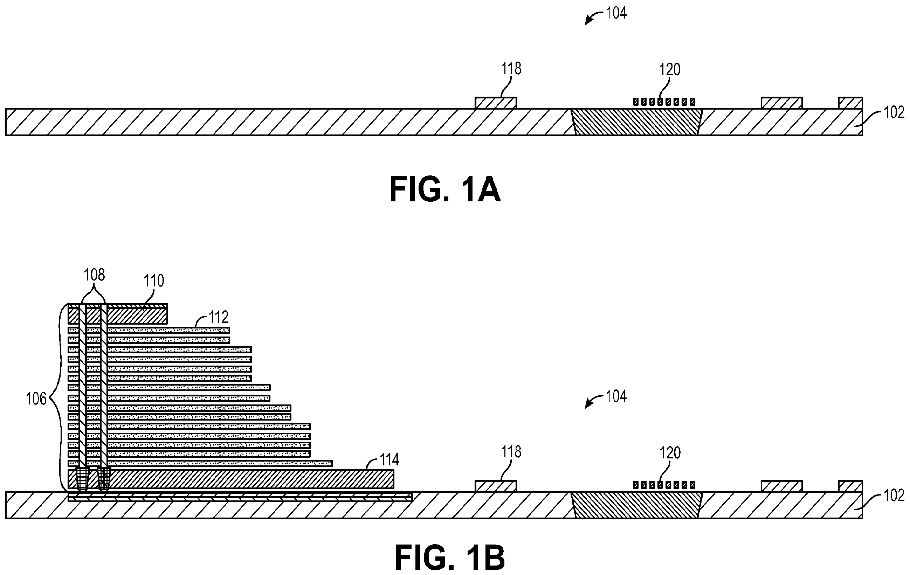

**Figures 1A-1C** illustrate an example of a cross-section of a 3D flash memory component with the CMOS periphery and the memory array on the same wafer at various stages of processing. Figure 1A illustrates building the CMOS periphery 104 on or in a substrate 102 (e.g., a silicon wafer). The CMOS periphery 104 includes control circuitry for accessing a memory array. The CMOS periphery 104 can include one or more of: address decoders, line drivers, sense amplifiers, charge-pumps, state machines, buffers, or various other types of circuitry. The CMOS periphery 104 typically includes transistors, such as n-channel metal-oxide semiconductor field-effect transistors (MOSFET), p-channel MOSFETs, or both. The boxes 118 represent the gates of the string drivers. String drivers are the transistors that supply the appropriate voltages to the wordlines of the memory devices. The CMOS periphery 104 also includes a layer of poly (polysilicon) 120.

Figure 1B illustrates a cross-section of the wafer of Figure 1A after building a storage array 106 on the substrate 102 and next to the periphery 104. The array 106 includes pillars 108 which form the storage cells (e.g., NAND flash storage cells) and conductive access lines to enable access to the storage cells. The conductive access lines formed in this operation include, for example, the wordlines 112, the SGS (select gate source) 114, and the SGD (select gate drain) 110.

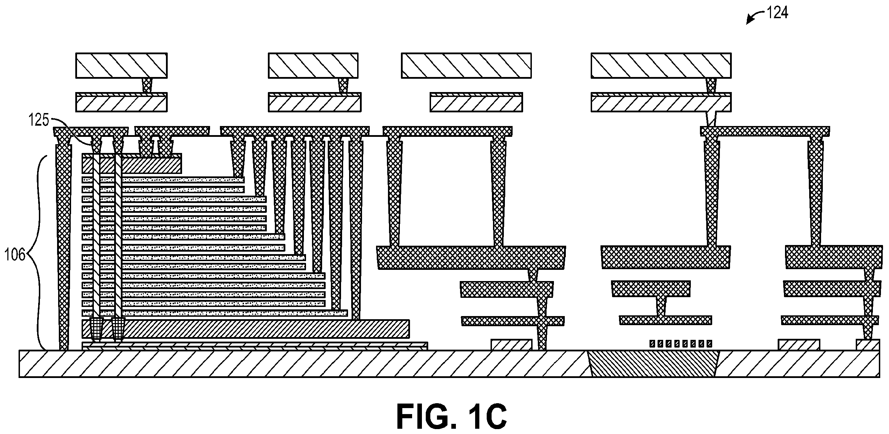

Figure 1C illustrates a cross-section of the wafer of Figure 1B after forming the final metal layers over the array and over the periphery. The metal layers include conductive interconnects (e.g., vias and other interconnects) 124 for coupling the periphery with the array and conductive access lines (e.g., bitlines 125) for accessing the storage cells of the array 106. Thus, the periphery 104, the array 106, and the conductive interconnects 124 are formed on the same wafer. Therefore, the periphery undergoes all the processing operations performed to form the array 106 and the conductive interconnects 124. Accordingly, materials used in the periphery are selected to withstand the high temperatures and thermal cycles typically used in processing the array.

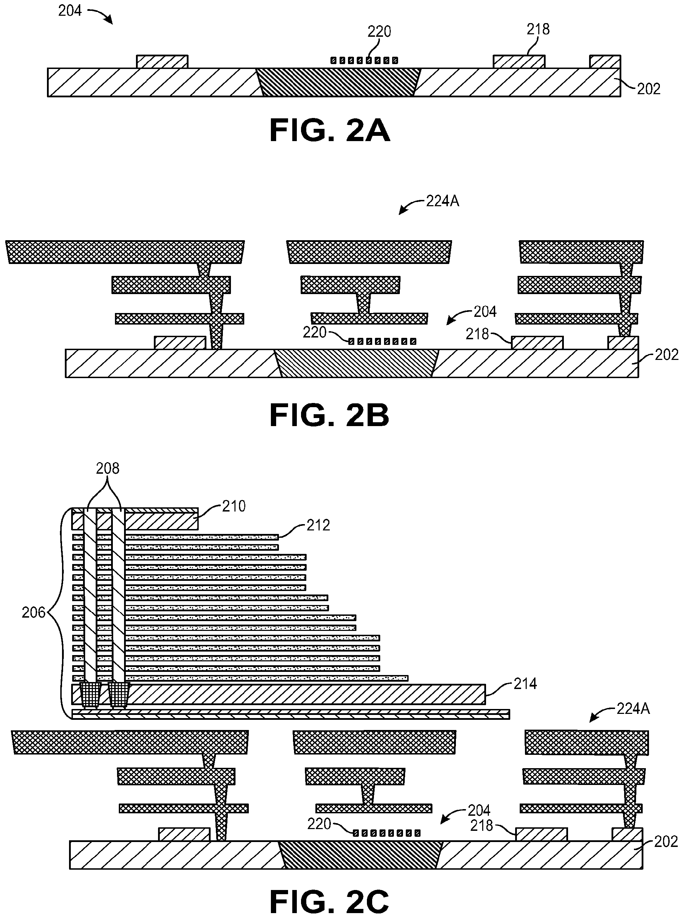

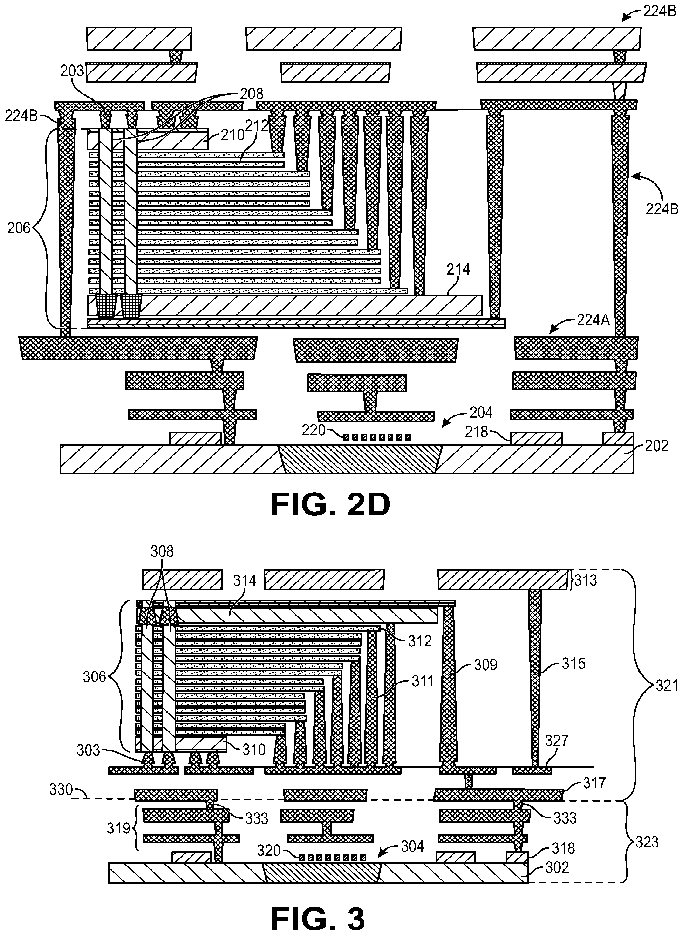

**Figures 2A-2D** also illustrate an example of a cross-section of a 3D flash memory component with the CMOS periphery and the memory array on the same wafer at various stages of processing. However, unlike Figures 1A-1C, which illustrate an example of CMOS next to the array, Figures 2A-2D illustrate an example of CMOS under the array (CuA). One advantage of forming the CMOS circuitry under the array instead of next to the array is a reduction in the total chip area. Referring to Figure 2A, the CMOS circuitry 204 (including transistors represented by the boxes 218 and poly 220) is formed first in the substrate 202. After forming the periphery 204, conductive interconnects 224A are formed over the CMOS circuitry 204, as is illustrated in Figure 2B. The array 206 (including pillars 208, wordlines 212, SGS 214 and SGD 210) is built on top of the conductive interconnects 224A and the CMOS circuitry 204, as is illustrated in Figure 2C. After forming the array 206, bitlines 203 and conductive interconnects 224B are formed over the array 206 to connect the array 206 to the CMOS periphery 204. Thus, like the example in Figures 1A-1C, the periphery 204, the array 206, and the conductive interconnects 224A and 224B are formed on the same wafer. Therefore, the periphery 204 undergoes all the processing operations performed to form the array 206 and the conductive interconnects 224A and 224B. Accordingly, materials that can be used in the periphery are limited to those that can withstand the high temperatures and thermal cycles typically used in processing the array.

In contrast, **Figure 3** illustrates a cross-section of a 3D storage component in which the CMOS circuitry and some of the interconnects are processed on a different wafer than the array. Thus, the component illustrated in Figure 3 includes two dies: one die 321 includes the array 306 and is processed on one wafer and another die 323 includes the CMOS circuitry 304 and is processed on a separate wafer. Prior to dicing the wafers, the wafers are bonded via a wafer-to-wafer bonding process to couple the array with the CMOS circuitry via the conductive interconnects on each wafer. Although wafer bonding pads are not illustrated in Figure 3, wafer bonding pads placed between the die 321 and 323 can be used to facilitate bonding of the two wafers. In an example in which there are no bonding pads, any conductive surface exposed at the bottom of one wafer can be bonded to an exposed conductive surface at the top of another wafer. For example, referring to Figure 3, the wafers can be bonded at the surfaces 333. Thus, the bonding can include "via-to-via" or "metal-to-metal" bonding without intervening bonding pads. Very good alignment of the dies can enable bonding the wafers without bonding pads. Even with very good alignment, the conductive interconnects of the two wafers may be partially misaligned as long as alignment is sufficient to electrically couple the interconnects on each wafer. In one example, a thin layer of nitride or an oxide is formed on the surface of the interconnects of one or both wafers to form a diffusion barrier (e.g., a copper diffusion barrier). Thus, referring to Figure 3, the interface 330 between the wafers can include a layer of oxide or nitride (unlike conventional components which would not have a layer of nitride or oxide between two conductive interconnects formed on the same wafer).

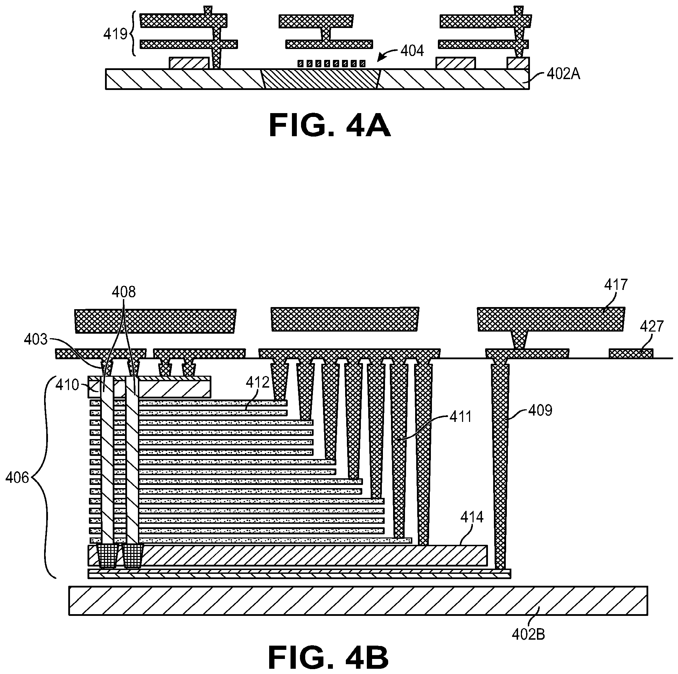

In the example illustrated in Figure 3, the array 306 is a 3D flash array. The array 306 is built using three-dimensional (3D) circuitry so that memory cells are built on top of the substrate. Such 3D circuit techniques may use a substrate (see substrate 402B of Figure 4B) as a mechanical base for the memory array without using the substrate itself for the circuitry of the memory array. In other examples, part of the array can be formed in the substrate. The array can include any type of 3D memory such as floating gate flash memory, charge-trap (e.g., replacement gate) flash memory, phase-change memory, resistive memory, ovonic memory, ferroelectric transistor random access memory (FeTRAM), nanowire memory, or any other 3D memory. In one example, the 3D flash array is a stacked NAND flash array, which stacks multiple floating gate or charge-trap flash memory cells in a vertical stack wired in a NAND (not AND) fashion. In another example, the 3D flash array includes NOR (not OR) storage cells.

In the example illustrated in Figure 3, the array 306 includes pillars 308 which form the storage cells, such as NAND flash storage cells. Figure 3 illustrates one deck, where each deck includes multiple tiers (layers). However, other examples may include arrays with two or more decks. In an example in which the storage cells include floating gate transistors, the cells can be programmed by charging a floating gate of the storage cell. The floating gate typically includes a conductive or semiconductor material. In an example in which the storage cells include charge trap, the storage cell can be programmed by storing charge in a charge trap. A charge trap typically includes an insulating material (such as silicon nitride or another insulating material capable of storing charge). Other storage cell technologies to enable storing data may also be used.

The storage array 306 includes conductive access lines to enable access to the storage cells. For example, the conductive access lines illustrated in Figure 3 include bitlines 303 (coming out of the page, as illustrated in Figure 3), wordlines 312, SGS (select gate source) 314, and SGD (select gate drain) 310. Also, between the CMOS circuitry 304 and the array 306, each die 321 and 323 includes conductive interconnects to couple the array 306 with the CMOS circuitry 304. For example, referring to the die 323, the interconnects 319 couple the CMOS circuitry 304 with the array 306. The die 321 also includes conductive interconnects (e.g., 313, 317, 327 and vias such as vias 309, 311 and 315) enable coupling the array to the CMOS circuitry or coupling the CMOS circuitry to other circuitry external to the storage component. In the illustrated example, vias 311 are coupled with the wordlines 312 in a staggered or staircase like configuration.

Under the array 306 is the control circuitry 304. In one example, the control circuitry 304 includes CMOS circuitry (and therefore is referred to as "CMOS under array" or CuA). In one such example, the CMOS circuitry 304 is formed first in the substrate 302, followed by formation of conductive interconnects 319 over the CMOS circuitry 304. Unlike conventional CuA devices, the array is not built on the same wafer as the CMOS circuitry. Instead, the array is built on a separate wafer, and then the wafers are bonded so that the array is over the CMOS circuitry. It is also possible to use a similar technique to form the CMOS circuitry next to the storage array. Although the term "CMOS under the array" indicates that that the array and CMOS circuitry are stacked over one another, in one example, the CMOS circuitry can be located partially under the array and partially next to the array. Regardless of whether the control circuitry is under or next to the array, the control circuitry may be referred to as the "periphery."

The CMOS circuitry 304 includes circuitry to control access to the array 306. The control circuitry 304 includes one or more of: address decoders, line drivers, sense amplifiers, charge-pumps, state machines, buffers, or various other types of circuitry. The control circuit 304 typically includes transistors. In one example, the control circuitry 304 includes n-channel metal-oxide semiconductor field-effect transistors (MOSFET), p-channel MOSFETs, or both. The control circuitry 304 can also include poly routing 320. The control circuitry 304 is coupled with the access lines using vias to allow electrical communication between the control circuitry 304 and the access lines, and thus enable access to the storage cells. The conductive access lines, conductive interconnects, and vias are formed from a conductive (e.g., metal) or semiconductive material to enable electrical coupling between components.

In one example, prior to bonding the two wafers, one of the wafers is flipped. In the example illustrated in Figure 3, the wafer including the array is flipped, resulting in an array that is upside down when compared to conventional 3D NAND arrays. When the wafer with the array is flipped, the features of the array are reversed. For example, the vias 311 and 309 and the pillars 308 have a smaller width at the top than at the bottom (the end near the CMOS circuitry 304). In contrast, the via 315 is formed after bonding the wafers, so the top of the via is wider than the bottom of the via, unlike the vias 309 and 311. Also, the staircase shape of the wordlines is reversed so that the shortest wordlines are at the bottom and the longest wordlines are at the top of the array. In another example, the wafer with the array is not flipped prior to bonding. However, flipping the wafer with the array can simplify integration.

Forming the CMOS circuitry and array on separate wafers and then bonding the wafers to form the 3D storage component can enable the use of higher performance materials for the interconnects. When building the CMOS and array on the same wafer, there is typically a compromise made either for the CMOS or array optimizations because they each observe the same processing operations. Thus, tungsten or another metal that can withstand thermal cycles is typically used for all the interconnects. However, forming the CMOS circuitry and array separately enables the use of different materials for the interconnects of each wafer. For example, the interconnects on the wafer with the array can include tungsten or another material that can withstand the thermal cycles performed during the formation of the array, and the interconnects on the other wafer can include a material such as copper or another different material. For example, referring to Figure 3, the interconnects 319 of the die 323 can include one metal (e.g., copper) and the interconnects 317 of the die 321 can include a different metal (e.g., tungsten).

Forming the CMOS circuitry and array on separate wafers and then bonding the wafers to form the 3D storage component also enables improved bitline access. Because the wafer with the array is flipped prior to bonding, the bitlines 303 are closer to the CMOS circuitry 304 that in traditional 3D NAND components. Therefore, in contrast to traditional 3D NAND components, the bitlines can be accessed by the CMOS circuitry directly via the interconnects between the bitlines 303 and the CMOS circuitry 304 without needing to pass through the array 306 and without needing to form additional conductive interconnects on the edge of the array.

Thus, building the periphery and array on separate wafers can enable several optimizations that are not possible in conventional 3D storage components. For example, the CMOS devices processed on a separate wafer do not have to withstand the thermal cycles used during memory cell processing and therefore can be better optimized with less overall thermal cycle budget. Similarly, the total thermal budget to optimize the memory cell performance does have to take into account its impact on the CMOS device performance as the CMOS devices are now processed on a separate wafer. In addition, the interconnects that are under the memory cells can utilize material with lower resistances (such as Cu) as they do not see the high temperature process steps used during cell processing.

**Figures 4A-4E** illustrate an example of a 3D flash component with the CMOS circuitry and array on separate bonded dies in various stages of processing. The 3D flash component in Figures 4A-4D is formed by processing the array and CMOS circuitry on separate wafers and then bonding the wafers via wafer-to-wafer bonding. Figure 4A illustrates one wafer (wafer 1) in which the CMOS circuitry 404 is formed in and/or over the substrate 402. Conductive interconnects 419 are formed over the CMOS circuitry 404. Forming conductive interconnects typically includes depositing a metal layer (e.g., over the CMOS circuitry) and etching the metal layer to form the conductive interconnects. In one example, a conductive material such as copper is used for forming the conductive interconnects.

The array 406 is formed over a substrate 402B of a separate wafer (wafer 2), as illustrated in Figure 4B. The array can be the same or similar to the array 306 of Figure 3, described above. The array 406 includes pillars 408, wordlines 412, bitlines 403, SGS 414, and SGD 410. Conductive interconnects 417, 427, 411, and 409 are formed over the array. Forming the conductive interconnects typically includes depositing a metal layer (e.g., over the array) and etching the metal layer to form the conductive interconnects. Forming vias typically involves etching a via through the underlying layers and depositing a metal or other conductive material in the etched via. In one example, the conductive interconnects on wafer 2 are formed from tungsten or another metal that can withstand the thermal cycles involved in processing the array 406. Thus, in one such example, the conductive interconnects on wafer 2 are formed from a different metal than the conductive interconnects on wafer 1.

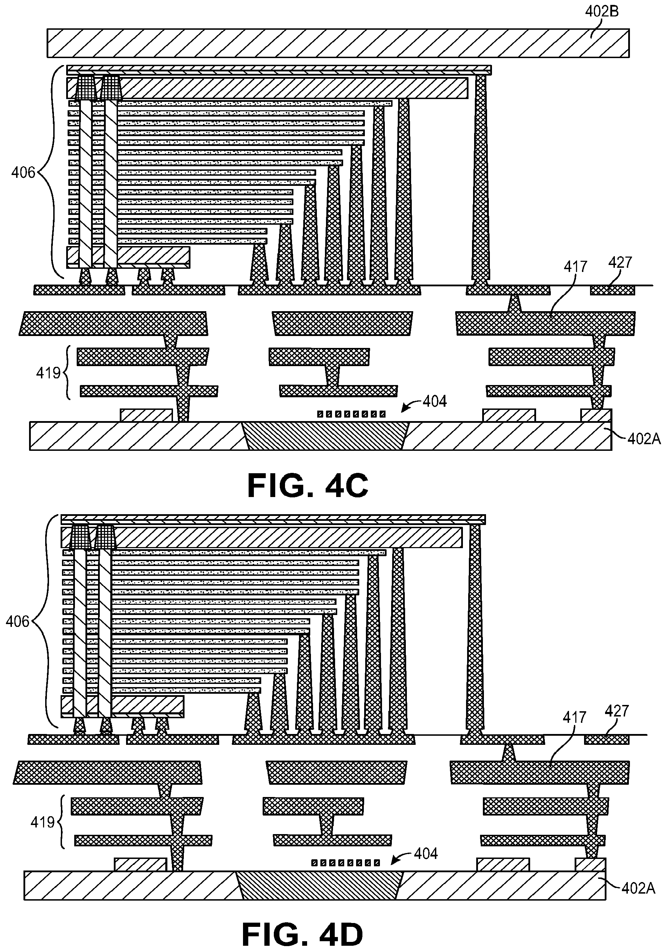

Wafer 2 is then flipped upside down and bonded on top of wafer 1, as illustrated in Figure 4C. Bonding the wafers together involves wafer-to-wafer bonding techniques to either bond together bonding pads that are attached to the wafers or to bond the wafers together at conductive contacts of the wafers. Wafer-to-wafer bonding with sub-micron alignment accuracy is feasible and can involve the following process flow. First the wafers are cleaned and the surfaces are activated (by surface treatment) to enhance the bonding. This is followed by the wafers being aligned using face to face (F2F) precision optical alignment, which enables sub-µm alignment precision. Once aligned, wafers are bonded by thermal-compression in a regular cleanroom atmosphere. Optimized tooling and process sequences can ensure that sub-µm alignment precision is maintained across the entire wafer.

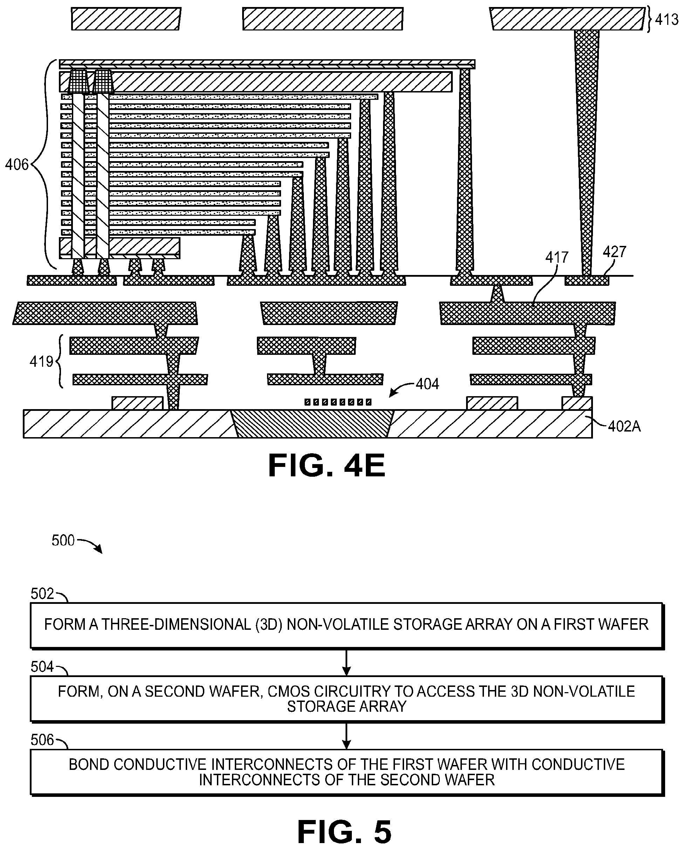

After bonding, the bulk of wafer 2 (e.g., the substrate 402B) is removed, keeping the array 406 and the interconnects, as illustrated in Figure 4D. The substrate 402B can be removed by performing chemical mechanical planarization (CMP) or other suitable processing on the backside of the wafer (e.g., the bottom of the wafer, which is now facing up after flipping and bonding). In Figure 4E, a top layer 413 of metal is connected to the metal layer 427 just below the array layer through a via 415, completing the NAND memory component.

**Figure 5** is a flow diagram of an example of a method of forming a 3D flash storage device with the array and CMOS on separately processed and bonded wafers. The method 500 of Figure 5 can be used to form a 3D flash storage component such as the component illustrated in Figure 3. The following operations may involve semiconductor processing techniques including deposition, etch, lithography, annealing, polishing, doping (e.g., via implant or other process) and/or other semiconductor processing techniques.

The method 500 begins with forming a 3D non-volatile storage array on a first wafer, at operation 502. The non-volatile storage array can be, for example, a 3D NAND flash storage (memory) array. For example, Figure 4B illustrates an example of a NAND flash array being formed over a first wafer (wafer 2). The CMOS circuitry for accessing the array is formed on a second wafer, at operation 504. For example, Figure 4A illustrates an example of CMOS circuitry being formed in and/or on a second wafer (wafer 1). The wafers are then bonded together conductive interconnects, at operation 506. As mentioned above, bonding pads may optionally be attached to the wafers, in which case the wafers can be bonded with one another at the bonding pads.

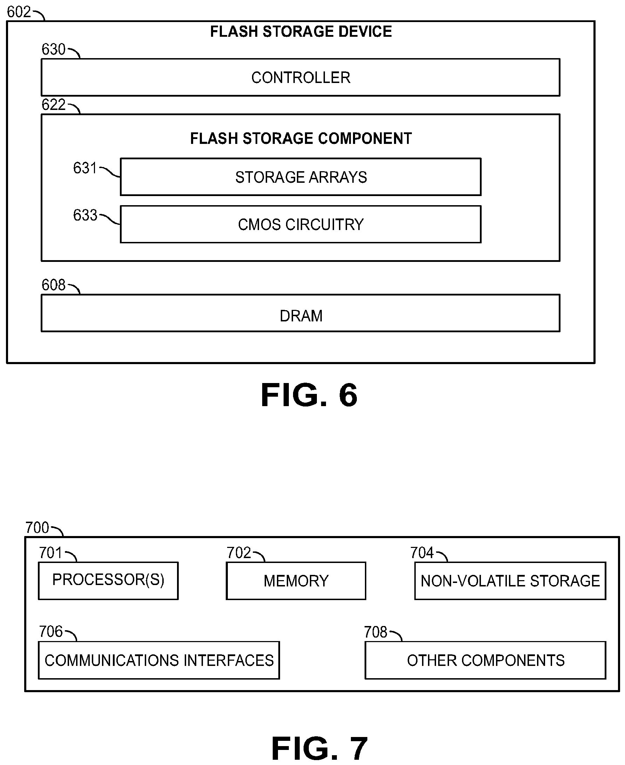

**Figure 6** illustrates a block diagram of a flash storage device 602 in which a 3D storage component with the array and CMOS circuitry on separately processed and bonded wafers can be included, in accordance with one example. Although the term flash storage is used for device 602 and throughout this disclosure, a flash storage device can also be referred to as a flash memory device. In one example, the flash storage device 602 is a solid-state drive (SSD) that includes a flash storage component 622. The flash storage component 622 includes nonvolatile storage arrays 631 for storing data. The flash storage component 622 also include CMOS circuitry 633 to access the storage arrays 631. The flash storage component 622 can include multiple dies bonded together, as discussed above. Each die can include a storage array and shared CMOS circuitry on a given die enables access to arrays on multiple dies. Although a single flash storage component is illustrated in Figure 6, the flash storage device 602 can include more than one flash storage component.

In one example, the flash storage device 602 can be a flash-based drive connected to a processor using a PCI Express (PCIe), serial advanced technology attachment (ATA), a parallel ATA, and/or a universal serial bus (USB) interface. The storage arrays 631 can include one or more of NAND flash, NOR flash, phase change memory (PCM), phase change memory with switch (PCMS), resistive memory, or other nonvolatile storage media. Data may be stored in single level cell (SLC), triple level cell (TLC), Quad level cell (QLC) and/or multi-level cell (MLC) format.

In addition to the nonvolatile storage 631, the flash storage device 602 can also include DRAM 608 (or other volatile memory). The DRAM 608 includes volatile memory that can store data while the flash storage device 602 is powered on (e.g., operational). The DRAM can comply with a standard promulgated by the Joint Electron Device Engineering Council (JEDEC), such as JESD79F for DDR Double Data Rate (DDR) SDRAM, JESD79-2F for DDR2 SDRAM, JESD79-3F for DDR3 SDRAM, JESD79-4A for DDR4 SDRAM, LPDDR3 (low power dual data rate version 3, original release by JEDEC (Joint Electronic Device Engineering Council) JESD209-3B, August 2013 by JEDEC), LPDDR4 (LOW POWER DOUBLE DATA RATE (LPDDR) version 4, JESD209-4, originally published by JEDEC in August 2014, or other JEDEC standards (these standards are available at www.jedec.org). Other volatile memory may be used. Some flash storage devices do not include a DRAM (e.g., "DRAM-less" SSDs). In one such example, the flash storage device can include an SSD controller memory (not shown), such as an SRAM. The DRAM 608 can be used to store data related to the operation of the flash storage device 602, such as a logical-to-physical indirection table or other such information.

The flash storage device 602 also includes a controller 630 to control access to the storage component 622. In one example, the controller 630 includes an input/output (I/O) interface to the storage component 622 and includes an interface to the host (not shown in Figure 6). The controller 630 includes hardware logic (e.g., command logic) to communicate to control the writing to storage 622 and reading from storage 622. Command logic includes circuitry to generate and issue commands to read the storage cells of the storage 631. The CMOS circuitry applies voltage strobes to read and write to the storage cells of the storage arrays 631 in response to commands from the controller 630. Thus, CMOS circuitry 633 include circuitry to decode commands from the controller 630 and apply read or write strobes to the memory cells in accordance with the received commands. The controller can also include error code correction (ECC) logic to detect and correct errors in data read from storage 631. The controller 630 may be an application specific integrated circuit controller (ASIC) device connected to an interface such as a serial ATA or an integrated drive electronics controller. In another example, the controller 630 includes a processor or other processing circuitry (not shown). In one example, the controller 630 may be included in a System-on-a-Chip (SoC) onto a single integrated circuit chip.

The flash storage device 602 can also include firmware (not shown). The firmware can perform a variety of functions such as translation, garbage collection, wear levelling, and other functions for the operation and optimization of flash storage device 602. In one example, the firmware can include the flash translation layer (FTL), which includes logic to provide indirection to identify the physical addresses space for logical addresses such as logical block addresses (LBAs) of requests received from filesystem.

The flash storage device 602 may exist within the confines of a computer's package (e.g., within a laptop/notebook or other computer) or the flash storage device 602 may also be accessed via a larger network such as a local area network (e.g., an Ethernet network), or even a wide area network (such as a wireless cellular network, the Internet, etc.).

**Figure 7** provides an exemplary depiction of a computing system 700 (e.g., a smartphone, a tablet computer, a laptop computer, a desktop computer, a server computer, etc.) that can include a 3D storage device in which the array and CMOS circuitry are formed on separately processed and bonded wafers. As observed in Figure 7, the system 700 may include one or more processors or processing units 701 (e.g., host processor(s)). The processor(s) 701 may include one or more central processing units (CPUs), each of which may include, e.g., a plurality of general purpose processing cores. The processor(s) 701 may also or alternatively include one or more graphics processing units (GPUs) or other processing units. The processor(s) 701 may include memory management logic (e.g., a memory controller) and I/O control logic.

The system 700 also includes memory 702 (e.g., system memory), non-volatile storage 704, communications interfaces 706, and other components 708. The other components may include, for example, a display (e.g., touchscreen, flat-panel), a power supply (e.g., a battery or/or other power supply), sensors, power management logic, or other components. The communications interfaces 706 may include logic and/or features to support a communication interface. For these examples, communications interface 706 may include one or more communication interfaces that operate according to various communication protocols or standards to communicate over direct or network communication links or channels. Direct communications may occur via use of communication protocols or standards described in one or more industry standards (including progenies and variants) such as those associated with the PCIe specification. Network communications may occur via use of communication protocols or standards such those described in one or more Ethernet standards promulgated by IEEE. For example, one such Ethernet standard may include IEEE 802.3. Network communication may also occur according to one or more OpenFlow specifications such as the OpenFlow Switch Specification. Other examples of communications interfaces include, for example, a local wired point-to-point link (e.g., USB) interface, a wireless local area network (e.g., WiFi) interface, a wireless point-to-point link (e.g., Bluetooth) interface, a Global Positioning System interface, and/or other interfaces.

The computing system also includes non-volatile storage 704, which may be the mass storage component of the system. The non-volatile storage 704 can be similar to, or the same as, the flash storage device 702 of Figure 7, described above. Non-volatile types of memory may include byte or block addressable non-volatile memory such as, but not limited to, multi-threshold level NAND flash memory, NOR flash memory, single or multi-level phase change memory (PCM), resistive memory, nanowire memory, ferroelectric transistor random access memory (FeTRAM), magnetoresistive random access memory (MRAM) that incorporates memristor technology, spin transfer torque MRAM (STT-MRAM), 3-dimensional (3D) cross-point memory structure that includes chalcogenide phase change material (e.g., chalcogenide glass) hereinafter referred to as "3D cross-point memory", or a combination of any of the above. In one example, the non-volatile storage 704 may include mass storage that is composed of one or more SSDs. SSDs can be composed of flash memory chips that include CMOS circuitry and the array processed on separate wafers that are then bonded via wafer-to-wafer bonding techniques as described above.

Thus, by processing the CMOS circuitry and array on separate wafers, the periphery CMOS and interconnects do not have to withstand the thermal cycles involved in processing the memory array, which enables optimizations for the CMOS transistors and the use low resistive material for interconnects.

The following are some examples. In one example, a non-volatile storage component includes a first die including a three-dimensional (3D) array of non-volatile storage cells and a second die bonded with the first die. The second die includes CMOS (complementary metal oxide semiconductor) circuitry to access the 3D array of non-volatile storage cells. In one example, the first die includes first conductive interconnects coupled with the 3D array of non-volatile storage cells, the first conductive interconnects including a first metal. The second die includes second conductive interconnects coupled with the CMOS circuitry, the second conductive interconnects including a second metal that is different than the first metal. The first conductive interconnects are bonded with the second conductive interconnects to couple the 3D array with the CMOS circuitry. In one such example, the first metal includes tungsten and the second metal includes copper. In one example, the 3D array of non-volatile storage cells of the first die is located over the CMOS circuitry of the second die. The 3D array of non-volatile storage cells includes pillars, a wider end of the pillars located proximate to a side of the first die that is bonded with the second die. In one example, the non-volatile storage component includes a layer of a metal nitride or a metal oxide between the first conductive interconnects of the first die and the second conductive interconnects of the second die.

In one example, the component includes first conductive vias on the first die. The first conductive vias couple wordlines with conductive interconnects of the first die. In one such example, the component includes second conductive vias on the second die. The second conductive vias couple the CMOS circuitry with the first die. In one such example, the first conductive vias of the first die are upside down relative to the second conductive vias of the second die. In one example, a third conductive via on the first die couples conductive interconnects at a bottom of the first die with conductive interconnects at a top of the first die. In one such example, the third conductive via upside down relative to the first conductive vias of the first die. In one example, the component further includes bitlines to access the 3D array of non-volatile storage cells, the bitlines located on a side of the 3D array proximate to the CMOS circuitry.

In one example, a system includes a processor and a non-volatile storage device coupled with the processor. The storage device includes a first die including a three-dimensional (3D) array of non-volatile storage cells and a second die bonded with the first die, the second die including CMOS (complementary metal oxide semiconductor) circuitry to access the 3D array of non-volatile storage cells.

In one example, a three-dimensional (3D) NAND flash memory component includes a first die including a three-dimensional (3D) array of NAND flash memory cells and a second die bonded with the first die, the second die including control circuitry to access the 3D array of NAND flash memory cells.

In one example, a method of manufacturing a non-volatile storage device involves forming a three-dimensional (3D) non-volatile storage array on a first wafer, forming, on a second wafer, CMOS circuitry to access the 3D non-volatile storage array, and bonding conductive interconnects of the first wafer with conductive interconnects of the second wafer. In one example, the method further involves forming the first conductive interconnects over the 3D non-volatile storage array of the first wafer, forming the second conductive interconnects over the CMOS circuitry of the second wafer, and prior to bonding, flipping the first wafer and aligning the first conductive interconnects with the second conductive interconnects. In one example, the method involves, after bonding, removing a bulk of the first wafer over which the 3D non-volatile storage array was formed, the 3D non-volatile storage array and the first conductive interconnects remaining after the removal and forming a metal layer over remaining layers of the first wafer, the metal layer coupled with the first conductive interconnects via a via. In one example, forming the first conductive interconnects includes depositing a first metal layer over the array and etching the first metal layer to form the first conductive interconnects and forming the second conductive interconnects includes depositing a second metal layer that includes a different metal than the first metal layer and etching the second metal layer to form the second conductive interconnects.

Embodiments of the invention may include various processes as set forth above. The processes may be embodied in machine-executable instructions. The instructions can be used to cause a general-purpose or special-purpose processor to perform certain processes. Alternatively, these processes may be performed by specific/custom hardware components that contain hardwired logic circuitry or programmable logic circuitry (e.g., FPGA, PLD) for performing the processes, or by any combination of programmed computer components and custom hardware components.

Elements of the present invention may also be provided as a machine-readable medium for storing the machine-executable instructions. The machine-readable medium may include, but is not limited to, floppy diskettes, optical disks, CD-ROMs, and magneto-optical disks, FLASH memory, ROMs, RAMs, EPROMs, EEPROMs, magnetic or optical cards, propagation media or other type of media/machine-readable medium suitable for storing electronic instructions. For example, the present invention may be downloaded as a computer program which may be transferred from a remote computer (e.g., a server) to a requesting computer (e.g., a client) by way of data signals embodied in a carrier wave or other propagation medium via a communication link (e.g., a modem or network connection).

Flow diagrams as illustrated herein provide examples of sequences of various process actions. The flow diagrams can indicate operations to be executed by a software or firmware routine, as well as physical operations. In one example, a flow diagram can illustrate the state of a finite state machine (FSM), which can be implemented in hardware, software, or a combination. Although shown in a particular sequence or order, unless otherwise specified, the order of the actions can be modified. Thus, the illustrated embodiments should be understood only as an example, and the process can be performed in a different order, and some actions can be performed in parallel. Additionally, one or more actions can be omitted in various examples; thus, not all actions are required in every embodiment. Other process flows are possible.

To the extent various operations or functions are described herein, they can be described or defined as software code, instructions, configuration, data, or a combination. The content can be directly executable ("object" or "executable" form), source code, or difference code ("delta" or "patch" code). The software content of the embodiments described herein can be provided via an article of manufacture with the content stored thereon, or via a method of operating a communication interface to send data via the communication interface. A machine-readable storage medium can cause a machine to perform the functions or operations described and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters or sending signals, or both, to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to the disclosed embodiments and implementations of the invention without departing from their scope. Terms used above to describe the orientation and position of features such as 'top', 'bottom', 'over', 'under', and other such terms describing position are intended to clarify the relative location of features relative to other features, and do not describe a fixed or absolute position. For example, a wafer that is described as the top wafer that is above or over a bottom wafer could be described as a bottom wafer that is under or below a top wafer. Therefore, the illustrations and examples herein should be construed in an illustrative, and not a restrictive sense. The scope of the invention should be measured solely by reference to the claims that follow.

## Claims

1. A non-volatile storage component comprising:
a first die including a three-dimensional (3D) array of non-volatile storage cells; and
a second die bonded with the first die, the second die including CMOS (complementary metal oxide semiconductor) circuitry to access the 3D array of non-volatile storage cells.

2. The non-volatile storage component of claim 1, wherein:
the first die includes first conductive interconnects coupled with the 3D array of non-volatile storage cells, the first conductive interconnects including a first metal; and
the second die includes second conductive interconnects coupled with the CMOS circuitry, the second conductive interconnects including a second metal that is different than the first metal;
wherein the first conductive interconnects are bonded with the second conductive interconnects to couple the 3D array with the CMOS circuitry.

3. The non-volatile storage component of claim 2, wherein the first metal includes tungsten and the second metal includes copper.

4. The non-volatile storage component of claim 1, wherein:
the 3D array of non-volatile storage cells of the first die is located over the CMOS circuitry of the second die; and
the 3D array of non-volatile storage cells includes pillars, a wider end of the pillars located proximate to a side of the first die that is bonded with the second die.

5. The non-volatile storage component of claim 2, further comprising:
a layer of a metal nitride or a metal oxide between the first conductive interconnects of the first die and the second conductive interconnects of the second die.

6. The non-volatile storage component of claim 1, further comprising:
first conductive vias on the first die, the first conductive vias coupling wordlines with conductive interconnects of the first die; and
second conductive vias on the second die, the second conductive vias coupling the CMOS circuitry with the first die, wherein the first conductive vias of the first die are upside down relative to the second conductive vias of the second die.

7. The non-volatile storage component of claim 6, further comprising:
a third conductive via on the first die, the third conductive via coupling conductive interconnects at a bottom of the first die with conductive interconnects at a top of the first die, the third conductive via upside down relative to the first conductive vias of the first die.

8. The non-volatile storage component of claim 1, further comprising:
bitlines to access the 3D array of non-volatile storage cells, the bitlines located on a side of the 3D array proximate to the CMOS circuitry.

9. The non-volatile storage component of claim 1, wherein:
the three-dimensional (3D) array of non-volatile storage cells comprises a 3D array of NAND flash memory cells.

10. The non-volatile storage component of claim 9, wherein:
the CMOS circuitry comprises control circuitry to access the 3D array of NAND flash memory cells.

11. The non-volatile storage component of claim 1, further comprising:
wordlines to access the 3D array of non-volatile storage cells, wherein shortest of the wordlines are proximate to the CMOS circuitry and longest of the wordlines are further from the CMOS circuitry than the shortest wordlines.
